# EUROPEAN PATENT APPLICATION

(11) **EP 2 096 493 A1**
(43) Date of publication of application: **02.09.2009**
(21) Application number: 07850280.4
(22) Date of filing: 07.12.2007
(51) Int. Cl.: G03F 7/004, G03F 7/033, H05K 3/00

(54) **PHOTOSENSITIVE ELEMENT**

(30) Priority: 19.12.2006 JP 2006341642
(71) Applicant: Hitachi Chemical Company, Ltd., Tokyo 163-0449 (JP)
(72) Inventor: KUBOTA, Masao, Hitachi-shi Ibaraki 317-8555 (JP)
(74) Representative: HOFFMANN EITLE
(86) International application number: PCT/JP2007/073702
(87) International publication number: WO 2008/075575

(57) **Abstract**

A photosensitive element wherein the haze of the support film 10 is no greater than 1.0% and the surface resistivity of the second main side 14 opposite the first main side 12 of the support film 10 is no greater than 10¹³ Ω, and the layer 20 composed of the photosensitive resin composition contains a photopolymerizing compound, a photopolymerization initiator and a binder polymer comprising a compound represented by the following general formula (I) and (meth)acrylic acid as monomer units.

H₂C=CR¹-COOR² (I)

[In formula (I), R¹ represents hydrogen or a methyl group, and R² represents a C3-7 alkyl group.]

## Description

### Technical Field

The present invention relates to a photosensitive element.

### Background Art

The field of manufacturing conventional printed wiring boards widely employs photosensitive elements comprising a layer made of a photosensitive resin composition ("photosensitive layer"), a support film and a protective film, as resist materials for etching, plating and the like. Printed wiring boards may be manufactured in the following manner, as an example. First, the protective film of the photosensitive element is released from the photosensitive layer and the photosensitive layer is then laminated on the conductive film of a circuit-forming board. After subsequent pattern exposure of the photosensitive layer, the unexposed sections are removed with a developing solution to form a resist pattern. The conductive film is patterned based on this resist pattern to form the printed wiring board.

The developing solution used for removal of the unexposed sections is usually an aqueous alkali solution such as a sodium hydrogencarbonate solution. For most purposes, the developing solution may be any one capable of dissolving the photosensitive layer to some extent, as the photosensitive layer becomes dissolved in the developing solution or dispersed in the developing solution during development. With increasingly higher densities of printed wiring boards in recent years, the contact areas between circuit-forming boards and the photosensitive layers that are used as resist materials have been decreasing in size. The photosensitive layer must therefore have excellent mechanical strength, chemical resistance and flexibility in the etching or plating step, while also having excellent adhesiveness for circuit-forming boards and high resolution for pattern formation.

When a photosensitive element is used to form a resist, usually the photosensitive layer is laminated on the board and exposed without peeling off the support film. An optically transparent material may be employed as the support film to facilitate exposure treatment. On the other hand, the support film must also be as thin as possible in order to obtain high resolution for pattern formation. However, a certain minimum level of thickness (generally 15 µm-25 µm) is required for the support film in order to allow coating of the photosensitive resin composition on the support film to a uniform thickness. For this reason, conventional support films tend to be unsuitable for the demands of higher resolution, from the standpoint of coatability of photosensitive resin compositions.

Methods for achieving high resolution include a method wherein a support film provided on a photosensitive element is peeled off before exposure so that exposure is accomplished without the support film. In this case, a phototool is often bonded directly onto the photosensitive layer. However, since the photosensitive layer usually has some level of pressure-sensitive adhesive property, it is difficult to remove the bonded phototool when exposure is carried out after directly bonding a phototool onto the photosensitive layer. In addition, the photosensitivity tends to be reduced by contamination of the phototool by the photosensitive layer, or exposure of the photosensitive layer to oxygen in the air when the support film is removed.

Various means have been proposed as improvements in this regard. For example, Patent documents 1 and 2 propose methods in which an interlayer is provided between the support film and photosensitive layer. Also, Patent documents 3 and 4 disclose methods in which two or more photosensitive layers are formed, the layer directly bonded to the phototool being one without an adhesive property.
[Patent document 1] Japanese Patent Application Laid-open No. S59-097138
[Patent document 2] Japanese Patent Application Laid-open No. S63-197942
[Patent document 3] Japanese Patent Application Laid-open No. H01-221735
[Patent document 4] Japanese Patent Application Laid-open No. H02-230149

### Disclosure of the Invention

### Problems to be Solved by the Invention

The methods described in Patent documents 1-4, however, require extra coating steps for formation of the interlayer or formation of multiple photosensitive layers, and this increases the number of manufacturing steps. In addition, the low thickness of the interlayer in the methods described in Patent documents 1 and 2 results in poorer handleability of the photosensitive element. Also, since the photosensitive layer is exposed to oxygen in the air in the methods described in Patent documents 3 and 4, it is difficult to maintain high photosensitivity.

One strategy for obtaining excellent resolution and photosensitivity for a photosensitive element without increasing the number of manufacturing steps may involve decreasing the haze of the support film to minimize light scattering during exposure. However, if the haze of the support film is simply reduced, contaminants such as dust and dirt in the surrounding environment will tend to adhere to it. Research by the present inventors has revealed that simply lowering the haze of the support film causes the photomask to attach to the support film and tends to cause more interference during manufacturing of the printed wiring board.

In recent years, semi-additive processes have been found to be effective as production processes for printed wiring boards with higher density. Resists used in such processes must satisfy requirements for adhesiveness, resolution, post-development resist form, flexibility and post-plating release properties. When the hydrophobicity of a resist is increased, this usually increases the adhesiveness of the resist but also tends to lower the post-plating release property. Conversely, increasing the hydrophilicity of a resist usually increases the post-plating release property but tends to lower the adhesiveness of the resist. As circuit widths continue to narrow, the smaller bonding areas of the circuit widths on boards introduce new problems of resist skirt trailing that had not been previously faced.

The present invention has been accomplished in light of these circumstances, and its object is to provide a photosensitive element that can sufficiently reduce adhesion of contaminants and attachment of photomasks onto support films, that allows formation of resist patterns with adequately high resolution and high sensitivity, and that has satisfactorily excellent adhesiveness, post-development resist form, flexibility and post-plating release properties.

### Means for Solving the Problems

As a result of much diligent research directed toward achieving the object stated above, the present inventors have found that adhesion of contaminants onto conventional photosensitive elements and attachment of photomasks onto support films is attributable to increased surface resistivity that occurs when the haze of the support film is reduced. The present inventors further found that the structure of the monomer unit composing the binder polymer affects the resolution, photosensitivity, adhesiveness, post-development resist form, flexibility and post-plating release property. It was therefore considered that the object stated above can be achieved by employing a film with not only low haze but also sufficiently low surface resistivity as the support film, and by employing a binder polymer containing a compound with a specific structure as the monomer unit, and the invention was thereupon completed.

The present invention provides a photosensitive element comprising a support film and a layer composed of a photosensitive resin composition which is formed on the first main side of the support film, wherein the haze of the support film is no greater than 1.0%, the surface resistivity of the second main side opposite the first main side of the support film is no greater than 10¹³ Ω, and the layer composed of the photosensitive resin composition contains a photopolymerizing compound, a photopolymerization initiator, and a binder polymer comprising a compound represented by the following general formula (I) and (meth)acrylic acid as monomer units.

[Chemical Formula 1] H₂C=CR¹-COOR² (I)

In formula (I), R¹ represents hydrogen or a methyl group, and R² represents a C3-7 alkyl group.

The photosensitive element described above can sufficiently reduce adhesion of contaminants and attachment of photomasks onto support films, while allowing formation of resist patterns with adequately high resolution and high sensitivity, and exhibiting excellent adhesiveness, post-development resist form, flexibility and post-plating release properties.

The binder polymer preferably contains as monomer units, 5-45 wt% of a compound represented by general formula (I) above and 20-40 wt% of (meth)acrylic acid.

Including a binder polymer having such a composition will produce a photosensitive element with even more excellent resolution, photosensitivity, adhesiveness, post-development resist form, flexibility and post-plating release properties.

The binder polymer preferably further contains styrene and/or a styrene derivative as monomer units.

This will further improve the resolution, photosensitivity, adhesiveness, post-development resist form, flexibility and post-plating release properties of the obtained photosensitive element.

The support film is preferably a film comprising as the major component one or more polymers selected from the group consisting of polyethylene terephthalate, polypropylene, polyethylene and polyesters.

This will even further reduce adhesion of contaminants and attachment of photomasks onto the support film in the obtained photosensitive element, and allow formation of resist patterns with superior resolution and sensitivity.

### Effect of the Invention

According to the invention it is possible to provide a photosensitive element that has sufficiently reduced adhesion of contaminants and attachment of photomasks onto support films, that allows formation of resist patterns with adequately high resolution and high sensitivity, and that exhibits satisfactorily excellent adhesiveness, post-development resist form, flexibility and post-plating release properties.

### Brief Description of the Drawings

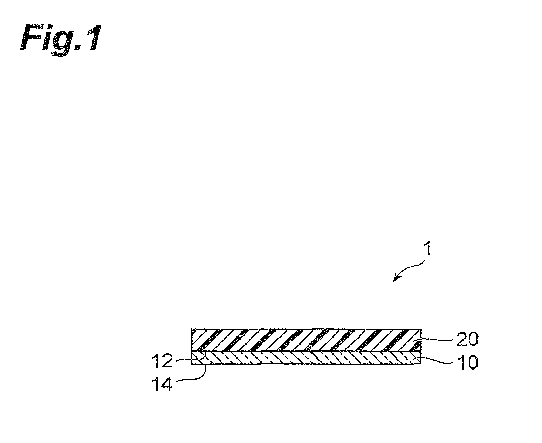

Fig. 1 is a schematic cross-sectional view showing a preferred embodiment of a photosensitive element of the invention.

### Explanation of Symbols

1: Photosensitive element, 10: support film, 12: first main side, 14: second main side, 20: layer composed of photosensitive resin composition (photosensitive layer).

### Best Modes for Carrying Out the Invention

Preferred embodiments of the invention will now be explained in detail, with reference to the accompanying drawings as necessary. Identical elements in the drawings will be referred to by like reference numerals and will be explained only once. Also, the dimensional proportions depicted in the drawings are not necessarily limitative. The term "(meth)acrylic acid" used in the present specification refers to "acrylic acid" and its corresponding "methacrylic acid". Similarly, the term "(meth)acrylate" refers to "acrylate" and its corresponding "methacrylate", "(meth)acryloxy" refers to "acryloxy" and its corresponding "methacryloxy", and "(meth)acryloyl" refers to "acryloyl" and its corresponding "methacryloyl".

Fig. 1 is a schematic cross-sectional view showing a preferred embodiment of a photosensitive element of the invention. The photosensitive element 1 shown in Fig. 1 has a construction with a support film 10 and a photosensitive layer 20. The photosensitive layer 20 is formed on the first main side 12 of the support film 10. The support film 10 has a second main side 14 opposite the first main side 12.

The haze of the support film 10 is no greater than 1.0%. The term "haze" refers to the degree of cloudiness, and it is the value measured using a commercially available haze meter (turbidimeter) according to the method of JIS K 7105.

The haze of the support film 10 is preferably 0-1.0%, more preferably 0-0.5% and even more preferably 0-0.3%. A haze of greater than 1.0% will tend to lower the resolution and disturb the form of the edges of the resist pattern.

The haze of the support film 10 can be adjusted within the numerical value range specified above by a method known in the prior art. For example, it may be adjusted by modifying the size or content of the inorganic and/or organic fine particles in the support film, or by using an A/B two-layer structure or an A/B/A three-layer structure for the support film and adjusting the film thickness of the A layer containing the fine particles.

The surface resistivity of the second main side 14 of the support film 10 (hereinafter referred to simply as "surface resistivity") is no greater than 10¹³ Ω. The surface resistivity is preferably no greater than 10¹² Ω and more preferably no greater than 10¹¹ Ω. There is no particular lower limit on the surface resistivity, but it is preferably at least 10⁶ Ω. If the surface resistivity exceeds 10¹³ Ω, static electricity will tend to be generated during lamination and exposure of the photosensitive layer 20 when a resist pattern is formed using the photosensitive element 1. This will tend to result in more adhesion of contaminants onto the support film 10 and attachment of the photomask and/or photosensitive layer 20 onto the support film 10. The surface resistivity can be measured using a 4329A High Resistance meter by Hewlett-Packard. The measuring temperature is 26°C and the measuring time is 1 minute.

The surface resistivity of the support film 10 can be adjusted within the aforementioned numerical value range by appropriate addition of an antistatic agent to the film starting material during production of the film. The surface resistivity of the support film 10 can be adjusted in the following manner. Specifically, the support film 10 has a multilayer structure of two or more layers, and a layer with a surface resistivity of no greater than 10¹³ Ω is used as the layer serving as the second main side. The layer serving as the second main side is laminated with the other layer(s) to obtain the support film 10. The thickness of the layer serving as the second main side is reduced for a support film 10 haze of no greater than 1.0%.

As mentioned above, the support film 10 may be a monolayer or a multilayer. However, it preferably has a multilayer structure with two or more layers to facilitate adjustment of both the haze and surface resistivity within the numerical value ranges specified above. The support film 10 may also contain an antistatic agent or the like if necessary, within a range that does not impair the photosensitive property.

The material of the support film 10 is not particularly restricted so long as it satisfies the conditions specified above for the haze and surface resistivity. The support film 10 may be, for example, a film containing one or more compounds selected from the group consisting of polyethylene terephthalate, polypropylene, polyethylene and polyester.

The support film 10 may be procured from among ordinary commercially available industrial films that are suitable for use as support films for the photosensitive element 1 with appropriately processing. As an example of an ordinary commercially available industrial film to be used as the support film 10, there may be mentioned the polyester film "COSMOSHINE A-1517" (trade name of Toyobo, Ltd.).

The thickness of the support film 10 is preferably 5-20 µm, more preferably 8-18 µm and even more preferably 10-16 µm, If the thickness is less than 5 µm, the support film 10 will tend to tear when it is released from the photosensitive element 1. If the thickness exceeds 20 µm, the resolution will tend to be reduced and economy may be compromised.

The photosensitive layer 20 is a layer composed of a photosensitive resin composition. The photosensitive resin composition of the photosensitive layer 20 contains a photopolymerizing compound, a photopolymerization initiator and a binder polymer which includes an alkyl (meth)acrylate ester as compounds represented by general formula (I) above and (meth)acrylic acid as monomer units.

The binder polymer preferably includes as monomer units, an alkyl (meth)acrylate ester as compounds represented by the general formula (I) and (meth)acrylic acid.

The number of carbon atoms of the alkyl group in the ester portion of the alkyl (meth)acrylate ester is preferably 3-7, more preferably 4-6 and especially 4. Fewer than 3 carbon atoms will tend to result in skirt trailing of the resist during development, creating a rough post-development resist form, while greater than 7 carbon atoms will tend to lower the adhesiveness and post-plating release property of the resist.

As examples of alkyl (meth)acrylate esters there may be mentioned propyl (meth)acrylate, butyl (meth)acrylate, pentyl (meth)acrylate, hexyl (meth)acrylate and heptyl (meth)acrylate, as well as their structural isomers. The alkyl groups may also be optionally substituted with hydroxyl, epoxy, halogens or the like.

The alkyl (meth)acrylate ester content is preferably 5-45 wt%, more preferably 15-40 wt% and most preferably 25-35 wt% with respect to the total binder polymer. If the content is less than 5 wt% the resist form will tend to be rough due to resist skirt trailing, while if it is greater than 45 wt% the adhesiveness of the resist will tend to be reduced.

The (meth)acrylic acid content is preferably 10-40 wt%, more preferably 15-35 wt% and most preferably 20-30 wt% with respect to the total binder polymer. If the content is less than 10 wt% the alkali developing property will tend to be reduced, and if it is greater than 40 wt% the adhesiveness will tend to be reduced.

The binder polymer may also include as monomer units other polymerizable monomers different from the alkyl (meth)acrylate esters and (meth)acrylic acid represented by general formula (I). As other polymerizable monomers there may be mentioned polymerizable styrene derivatives such as styrene, vinyltoluene, α-methylstyrene, p-methylstyrene and p-ethylstyrene, acrylamide, acrylonitrile, vinyl alcohol esters such as vinyl-n-butyl ether, tetrahydrofurfuryl (meth)acrylate, dimethylaminoethyl (meth)acrylate, diethylaminoethyl (meth)acrylate, glycidyl (meth)acrylate, 2,2,2-trifluoroethyl (meth)acrylate, 2,2,3,3-tetrafluoropropyl (meth)acrylate, α-bromo(meth)acrylic acid, α-chlor(meth)acrylic acid, β-furyl(meth)acrylic acid, β-styryl(meth)acrylic acid, maleic acid, maleic acid anhydride, maleic acid monoesters such as monomethyl malate, monoethyl malate and monoisopropyl malate, fumaric acid, cinnamic acid, α-cyanocinnamic acid, itaconic acid, crotonic acid and propiolic acid.

The binder polymer preferably contains styrene and/or a styrene derivative as monomer units from the viewpoint of adhesiveness and chemical resistance (plating resistance). When styrene and/or a styrene derivative is used as a copolymerizing component, the binder polymer preferably contains them at 3-20 wt%, more preferably 3-10 wt% and especially 3-7 wt%, in order to achieve satisfactory adhesiveness and release properties. A content of less than 3 wt% will tend to lower the adhesiveness, while a content of greater than 20 wt% will tend to lower the flexibility of the resist and reduce the post-plating release property.

The weight-average molecular weight of the binder polymer is preferably 15000-100000, more preferably 20000-80000 and even more preferably 30000-60000. If the weight-average molecular weight is less than 15000 the photosensitive layer will tend to be brittle, while if it is greater than 100000, strand-like development residues will tend to be generated, thus lowering the resolution. The weight-average molecular weight is measured by gel permeation chromatography, using the value in terms of standard polystyrene.

The acid value of the binder polymer is preferably 30-200 mgKOH/g and more preferably 45-150 mgKOH/g. If the acid value is less than 30 mgKOH/g the developing time will tend to be longer, and if it is greater than 200 mgKOH/g the acidity with respect to the alkali developing solution of the photocured resist will tend to be lower.

Such binder polymers may be used alone or in combinations of two or more. As examples of binder polymer combinations when two or more are used in combination, there may be mentioned two or more binder polymers composed of different copolymerizing components, two or more binder polymers with different weight-average molecular weights, and two or more binder polymers with different dispersibilities. There may also be used a polymer having a multimode molecular weight distribution, as described in Japanese Patent Application Laid-open No. H11-327137.

The photopolymerizing compound is preferably a compound with a polymerizable ethylenic unsaturated bond in the molecule, and preferably it includes a compound having 4-40 of C2-6 oxyalkylene units (alkylene glycol units) in the molecule. Such photopolymerizing compounds can improve the compatibility with binder polymers.

As C2-6 oxyalkylene units there may be mentioned oxyethylene unit, oxypropylene unit, oxyisopropylene unit, oxybutylene unit, oxypentylene unit and oxyhexylene unit. Among these, preferred oxyalkylene units are oxyethylene unit and oxyisopropylene unit, from the viewpoint of improved resolution and plating resistance.

Of these photopolymerizing compounds, bisphenol A-based (meth)acrylate compounds and polyalkyleneglycol di(meth)acrylates are especially preferred since they will tend to more reliably produce the effect of the invention.

Preferred bisphenol A-based (meth)acrylate compounds are compounds represented by the following general formula (II).

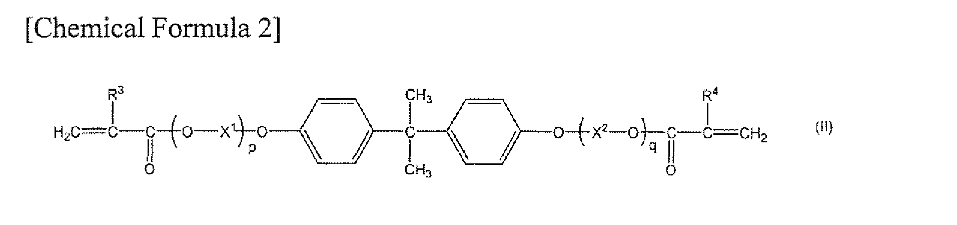

In formula (II), R³ and R⁴ each independently represent hydrogen or a methyl group, and preferably a methyl group. Also in formula (II), X¹ and X² each independently represent a C2-6 alkylene group. X¹ and X² are preferably ethylene or propylene groups, and more preferably ethylene groups. Also in formula (II), p and q each represent a positive integer selected so that the value of p+q is 4-40. The value of p+q is preferably 6-34, more preferably 8-30, even more preferably 8-28, especially preferably 8-20, even yet more preferably 8-16 and most preferably 8-12. If the value of p+q is less than 4, compatibility with the binder polymer will be reduced, and peeling will tend to occur when the photosensitive element has been laminated on a circuit-forming board. If the value of p+q exceeds 40, the hydrophilicity will increase and the resist image will more easily peel off during development, while the plating resistance for solder plating and the like will tend to be reduced. The resolution of the photosensitive element will also tend to be lower if the value is too high or too low.

As examples of C2-6 alkylene groups there may be mentioned ethylene, propylene, isopropylene, butylene, pentylene and hexylene. Ethylene or isopropylene groups are preferred from the viewpoint of improving the resolution and plating resistance.

The phenylene group in formula (II) above may be optionally substituted. As examples of substituents there may be mentioned halogen atoms, C1-20 alkyl, C3-10 cycloalkyl, C6-18 aryl, phenacyl, amino, C1-10 alkylamino, C2-20 dialkylamino, nitro, cyano, carbonyl, mercapto, C1-10 alkylmercapto, allyl, hydroxyl, C1-20 hydroxyalkyl, carboxyl, carboxyalkyl with 1-10 carbon atoms in the alkyl group, acyl with 1-10 carbon atoms in the alkyl group, C1-20 alkoxy, C1-20 alkoxycarbonyl, C2-10 alkylcarbonyl, C2-10 alkenyl, C2-10 N-alkylcarbamoyl and heterocyclic ring-containing groups, as well as aryl groups substituted with these substituents. The substituents mentioned above may form fused rings, or the hydrogen atoms in the substituents may be replaced by the aforementioned substituents, such as halogen atoms. If the number of substituents is two or more, the two or more substituents may be the same or different.

As examples of compounds represented by formula (II) above there may be mentioned bisphenol A-based (meth)acrylate compounds such as 2,2-bis(4-((rneth)acryloxypolyethoxy)phenyl)propanes, 2,2-bis(4-((meth)acryloxypolypropoxy)phenyl)propanes, 2,2-bis(4-((meth)acryloxypolybutoxy)phenyl)propanes and 2,2-bis(4-((meth)acryloxypolyethoxypolypropoxy)phenyl)propanes.

As examples of 2,2-bis(4-((meth)acryloxypolyethoxy)phenyl)propanes there may be mentioned 2,2-bis(4-((meth)acryloxydiethoxy)phenyl)propane, 2,2-bis(4-((meth)acryloxytriethoxy)phenyl)propane, 2,2-bis(4-((meth)acryloxytetraethoxy)phenyl)propane, 2,2-bis(4-((meth)acryloxypentaethoxy)phenyl)propane, 2,2-bis(4-((meth)acryloxyhexaethoxy)phenyl)propane, 2,2-bis(4-((meth)acryloxyheptaethoxy)phenyl)propane, 2,2-bis(4-((xneth)acrylaxyoctaethoxy)phenyl)propane, 2,2-bis(4-((nmth)acryloxynonaethoxy)phenyl)propane, 2,2-bis(4-((meth)acryloxydecaethoxy)phenyl)propane, 2,2-bis(4-((meth)acryloxyundecaethoxy)phenyl)propane, 2,2-bis(4-((meth)acryloxydodecaethoxy)phenyl)propane, 2,2-bis(4-((meth)acryloxytridecaethoxy)phenyl)propane, 2,2-bis(4-((meth)acryloxytetradecaethoxy)phenyl)propane, 2,2-bis(4-((meth)acryloxypentadeeaethoxy)phenyl)propane and 2,2-bis(4-((meth)acryloxyhexadecaethoxy)phenyl)propane. Of these, 2,2-bis(4-(methacryloxypentaethoxy)phenyl)propane is commercially available as BPE-500 (trade name of Shin-Nakamura Chemical Co., Ltd.). Also, 2,2-bis(4-(methacryloxypentadecaethoxy)phenyl)propane is commercially available as BPE-1300 (trade name of Shin-Nakamura Chemical Co., Ltd.). These may be used as single compounds or as combinations of two or more compounds.

As examples of 2,2-bis(4-((meth)acryloxypolyethoxypalypropoxy)phenyl)propanes there may be mentioned 2,2-bis(4-((meth)acryloxydiethoxyoctapropoxy)phenyl)propane, 2,2-bis(4-((meth)acryloxytetraethoxytetrapropoxy)phenyl)propane and 2,2-bis(4-((meth)acryloxyhexaethoxyhexapropoxy)phenyl)prapanea Any of these may be used alone or in combinations of two or more.

As preferred examples of polyalkyleneglycol di(meth)acrylate compounds there may be mentioned compounds represented by the following general formula (III).

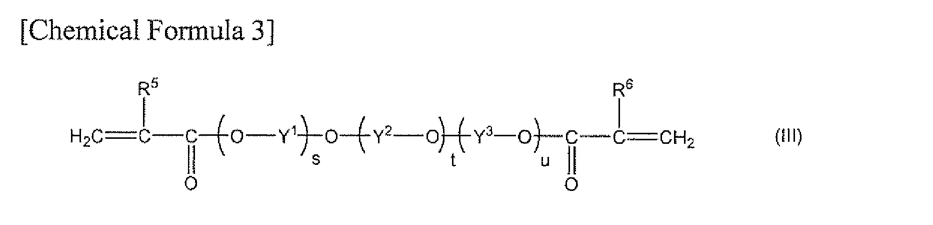

In formula (III), R⁵ and R⁶ each independently represent hydrogen or a C1-3 alkyl group, and they are preferably methyl groups. Also in formula (III), Y¹, Y² and Y³ represent C2-6 alkylene groups and are preferably ethylene or propylene groups. Also in formula (II), s, t and u each represent an integer of 0-30 selected so that the value of s+t+u is 4-40. The value of s+t+u is preferably 5-30, more preferably 8-23 and most preferably 10-15. If the value of s+t+u is less than 4, the boiling point of the compound will be lower and the odor of the photosensitive layer 20 will tend to be stronger. If s+t+u is greater than 40, the concentration of photoreactive sites per unit mass will be lower, tending to prevent a practical level of sensitivity.

When the oxyalkylene units (-(Y¹-O)ₛ-, _(Y²-O)ₜ- and -(Y³-O)ᵤ-) in formula (III) above contain, for example, multiple oxyethylene and oxypropylene units, the multiple oxyethylene and oxypropylene units do not need to be present in continuous blocks and may instead be randomly arranged.

Also, when the oxyalkylene unit is oxyisopropylene unit, the secondary carbon of the propylene group may be bonded to an oxygen atom and the primary carbon may be bonded to an oxygen atom.

As preferred examples of compounds represented by general formula (III) above there may be mentioned compounds represented by the following general formulas (IV), (V) and (VI). These may be used alone or in combinations of two or more. 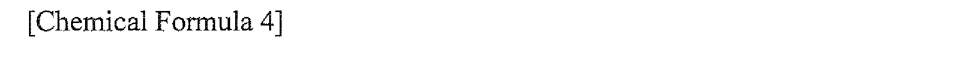 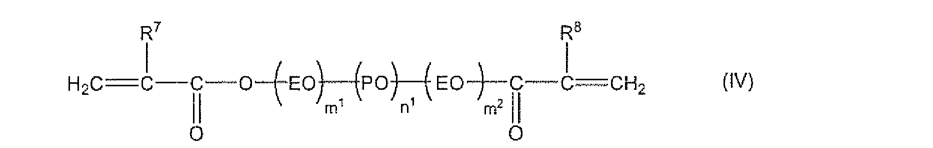 In formula (IV), R⁷ and R⁸ each independently represent hydrogen or a C1-3 alkyl group, EO represents an oxyethylene unit and PO represents an oxypropylene unit. Also, m¹, m² and n¹ each represent an integer of 1-30 selected so that m¹+m²+n¹ = 4-40. 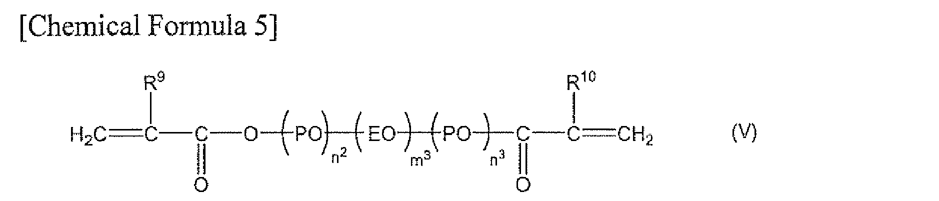 In formula (V), R⁹ and R¹⁰ each represent hydrogen or a C1-3 alkyl group, EO represents an oxyethylene unit and PO represents an oxypropylene unit. Also, m³, n² and n³ each represent an integer of 1-30 selected so that m³+n²+n³ = 4-40. 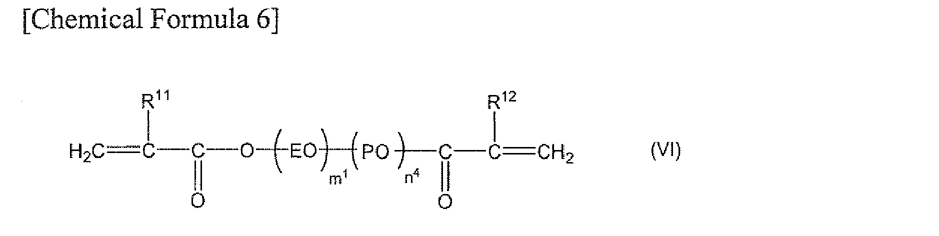 In formula (VI), R¹¹ and R¹² each represent hydrogen or a C1-3 alkyl group, EO represents an oxyethylene unit and PO represents an oxypropylene unit. Also, m⁴ and n⁴ each represent an integer of 1-30 selected so that m⁴+n⁴ = 4-40.

As examples for the C1-3 alkyl groups in general formulas (IV), (V) and (VI) there may be mentioned methyl, ethyl, n-propyl and isopropyl.

The total number of repeating oxyethylene units in general formulas (IV), (V) and (VI) (m¹+m², m³ and m⁴) is each independently preferably an integer of 1-30, more preferably an integer of 1-10, even more preferably an integer of 4-9 and most preferably an integer of 5-8. If the number of repeats exceeds 30, the tent reliability will tend to be reduced and the resist form may be rough.

The total number of repeating oxypropylene units in general formulas (IV), (V) and (VI) (n¹, n²+n³ and n⁴) is each independently preferably an integer of 1-30, more preferably an integer of 5-20, even more preferably an integer of 8-16 and most preferably an integer of 10-14. If the number of repeats exceeds 30, the resolution will be reduced and sludge will tend to be produced.

As a specific example of a compound represented by general formula (IV) above there may be mentioned a vinyl compound wherein R⁷ and R⁸ are methyl, m¹+m² = 4 (mean value) and n¹ = 12 (mean value) (trade name: FA-023M by Hitachi Chemical Co., Ltd.).

As a specific example of a compound represented by general formula (V) above there may be mentioned a vinyl compound wherein R⁹ and R¹⁰ are methyl, m³ = 6 (mean value) and n²+n³ =12 (mean value) (trade name: FA-024M by Hitachi Chemical Co., Ltd.).

As a specific example of a compound represented by general formula (VI) above there may be mentioned a vinyl compound wherein R¹¹ and R¹² are hydrogen, m⁴ = 1 (mean value) and n⁴ = 9 (mean value) (sample name: NK Ester HEMA-9P by Shin-Nakamura Chemical Co., Ltd.).

These may be used as single compounds or as combinations of two or more compounds.

The photopolymerizing compound may also contain another photopolymerizing compound with an ethylenic unsaturated bond in addition to the photopolymerizing compound with a polymerizable ethylenic unsaturated bond in the molecule. As examples of other photopolymerizing compounds with ethylenic unsaturated bonds there may be mentioned nonylphenoxypolyalkyleneoxy (meth)acrylates such as nonylphenoxypolyethyleneoxy (meth)acrylate, nonylphenoxypolypropyleneoxy (meth)acrylate and nonylphenoxypolyethyleneoxypolypropyleneoxy (meth)acrylate, phthalic acid-based compounds such as γ-chloro-β-hydroxypropyl-β'-(meth)acryloyloxyethyl-o-phthalate and β-hydroxyalkyl-β'-(meth)acryloyloxyalkyl-o-phthalate, and alkyl (meth)acrylate esters.

The photosensitive resin composition of the invention may also contain photopolymerizing compounds other than the photopolymerizing compounds mentioned above. As examples of such photopolymerizing compounds there may be mentioned compounds obtained by reacting α,β-unsaturated carboxylic acids with glycidyl group-containing compounds, and urethane monomers such as (meth)acrylate compounds with urethane bonds in the molecule.

As examples of photopolymerization initiators there may be mentioned benzophenones; N,N'-tetraalkyl-4,4'-diaminobenzophenones such as N,N'-tetramethyl-4,4'-diaminobenzophenone (Michler's ketone); aromatic ketones such as 2-benzyl-2-dimethylamino-1-(4-morpholinophenyl)-butanone-1 and 2-methyl-1-[4-(methylthio)phenyl]-2-mozpholino-propanone-1; quinone compounds such as alkylanthraquinones; benzoinether compounds such as benzoinalkyl ethers; benzoin compounds such as benzoin and alkylbenzoins; benzyl derivatives such as benzyldimethylketal; 2,4,5-triarylimidazole dimers such as 2-(o-chlorophenyl)-4,5-diphenylimidazole dimer, 2-(o-chlorophenyl)-4,5-di(methoxyphenyl)imidazole dimer, 2-(o-fluorophenyl)-4,5-diphenylimidazole dimer, 2-(o-methoxyphenyl)-4,5-diphenylimidazole dimer and 2-(p-methoxyphenyl)-4,5-diphenylimidazole dimer; acridine derivatives such as 9-phenylacridine and 1,7-bis(9,9'-acridinyl)heptane; N-phenylglycine, N-phenylglycine derivatives, coumarin-based compounds and the like. The substituents of two aryl groups of 2,4,5-triarylimidazole in a 2,4,5-triarylimidazole dimer may be identical to constitute a symmetrical compound, or they may be different to constitute an asymmetrical compound. From the viewpoint of improving adhesiveness and sensitivity, a 2,4,5-triarylimidazole dimer is preferred. These may be used alone or in combinations of two or more.

The content of the binder polymer is preferably 40-70 parts by weight and more preferably 50-60 parts by weight with respect to 100 parts by weight as the total of the binder polymer and photopolymerizing compound. If the content is less than 40 parts by weight the photocured composition will tend to be brittle, and if it is greater than 70 parts by weight the resolution and photosensitivity will tend to be lower.

The content of the photopolymerizing compound is preferably 30-60 parts by weight and more preferably 40-50 parts by weight with respect to 100 parts by weight as the total of the binder polymer and photopolymerizing compound. If the content is less than 30 parts by weight the resolution and photosensitivity will tend to be lower, and if it is greater than 60 parts by weight the photocured composition will tend to be brittle.

The content of the photopolymerization initiator is preferably 0.1-20 parts by weight and more preferably 0.2-10 parts by weight with respect to 100 parts by weight as the total of the binder polymer and photopolymerizing compound. If the content is less than 0.1 part by weight the photosensitivity will tend to be reduced, and if it is greater than 20 parts by weight the photoabsorption on the surface of the photosensitive resin composition during exposure will increase, tending to result in reduced interior photocuring.

The photosensitive resin composition may also contain, if necessary, additives such as photopolymerizing compounds with at least one cationic polymerizable cyclic ether group in the molecule (oxetane compounds, etc.), cationic polymerization initiators, dyes such as malachite green, photochromic agents such as tribromophenylsulfone and leuco crystal violet, thermal development inhibitors, plasticizers such as p-toluenesulfonamide, pigments, fillers, antifoaming agents, flame retardants, stabilizers, tackifiers, leveling agents, release promoters, antioxidants, aromas, imaging agents and thermal crosslinking agents. Any of these may be used alone or in combinations of two or more. These additives may be included at about 0.01-20 parts by weight each with respect to 100 parts by weight as the total of the binder polymer and photopolymerizing compound, so long as the object of the invention is not hindered.

The photosensitive resin composition may also be used in combination with a binder polymer composed of another copolymerizing component in addition to the binder polymer with a copolymerizing component described above. The binder polymer used in combination therewith is not particularly restricted so long as it is one that is conventionally used in photosensitive resin compositions, and as examples there may be mentioned acrylic-based resins, styrene-based resins, epoxy-based resins, amide-based resins, amide-epoxy-based resins, alkyd-based resins and phenol-based resins. Acrylic-based resins are preferred among these from the viewpoint of alkali developing properties. Any of these may be used alone or in combinations of two or more.

The photosensitive resin composition may, if necessary, be prepared as a solution in a solvent such as methanol, ethanol, acetone, methyl ethyl ketone, methylcellosolve, ethylcellosolve, toluene, N,N-dimethylformamide or propyleneglycol monomethyl ether, or a mixture of such solvents, at a solid content of about 30-60 wt%.

The photosensitive layer 20 of the photosensitive element 1 of the invention may be formed by coating the photosensitive resin composition onto the support film 10 and removing the solvent. Examples of coating methods that may be employed include known methods such as roll coating, comma coating, gravure coating, air knife coating, die coating and bar coating. The solvent removal can be carried out, for example, at a temperature of 70-150°C for about 5-30 minutes. The amount of residual organic solvent in the photosensitive layer 20 is preferably no greater than 2 wt% from the viewpoint of preventing diffusion of the organic solvent in subsequent steps.

The thickness of the photosensitive layer 20 formed in this manner is preferably 1-100 µm as the post-drying thickness. If the thickness is less than 1 µm, troubles may become more frequent during lamination of the photosensitive layer on the circuit-forming board, thus lowering the fabrication yield of printed wiring boards. If the thickness is greater than 100 µm, on the other hand, the resolution of the photosensitive layer 20 will tend to be lower, making it difficult to produce a high-density printed wiring board.

The photosensitive element 1 may comprise a protective film (not shown) on the main side of the photosensitive layer 20 opposite the main side that contacts the support film 10. The protective film is preferably a film such that the adhesive force between the photosensitive layer 20 and protective film is lower than the adhesive force between the photosensitive layer 20 and the support film 10. The protective film is preferably a low fisheye film. As protective films there may be mentioned, specifically, inactive polyolefin films such as polyethylene and polypropylene. From the viewpoint of releasability from the photosensitive layer 20, the protective film is preferably a polyethylene film. The thickness of the protective film is preferably about 1-100 µm, although this will differ depending on the purpose of use.

The photosensitive element 1 may also comprise interlayers or protective layers such as a cushion layer, adhesive layer, photoabsorbing layer and gas barrier layer in addition to the support film 10, the photosensitive layer 20 and the protective film.

The photosensitive element 1 of this embodiment may be stored in a condition where it is rolled around a cylindrical winding core, either alone or having a protective film further laminated on the photosensitive layer 20. In this case, it is preferably wound into a roll in such a manner that the support film 10 is the outermost layer. From the viewpoint of edge protection, an edge separator is preferably situated at the edge of the photosensitive element 1 that has been wound into a roll, while from the viewpoint of preventing edge fusion, the edge separator is preferably moisture-proof. The packaging method is preferably one that involves bundling in a black sheet with low moisture permeability.

The material of the winding core may be a plastic such as polyethylene resin, polypropylene resin, polystyrene resin, polyvinyl chloride resin or ABS resin (acrylonitrile-butadiene-styrene copolymer).

(Resist pattern forming method) The resist pattern forming method of this embodiment is a method comprising a lamination step in which the photosensitive element 1 is laminated on a circuit-forming board beginning with the photosensitive layer 20 and then the support film 10, an exposure step in which prescribed sections of the photosensitive layer 20 are irradiated with active light rays through the support film 10 to form photocured sections on the photosensitive layer 20, and a developing step in which the non-photocured sections of the photosensitive layer 20 are removed.

The method of laminating the photosensitive layer 20 on the circuit-forming board in the lamination step may be, for example, a laminating method in which the protective film is removed if a protective film is present on the photosensitive layer 20, and then the photosensitive layer 20 is contact bonded to the circuit-forming board at a pressure of about 0.1-1 MPa while heating to about 70-130°C. The lamination in this lamination step may also be carried out under reduced pressure. The laminating surface of the circuit-forming board will usually be a metal surface, but this is not restrictive. For further improved laminating properties, the circuit-forming board may be subjected to preheating treatment.

Next, a photomask with a negative or positive mask pattern is bonded onto the photosensitive layer 20 that has been laminated in the lamination step, being positioned on the second main side 14 of the support film 10. In the subsequent exposure step, the photosensitive layer 20 is irradiated with active light rays through the support film 10 in the form of an image, to form photocured sections on the photosensitive layer 20. The light source for the active light rays may be a publicly known light source that efficiently emits ultraviolet rays or visible light, such as, for example, a carbon arc lamp, mercury vapor arc lamp, high-pressure mercury lamp or xenon lamp. A laser direct writing exposure method may also be used.

After the exposure step, the photomask is released from the support film 10. The support film 10 is also released and removed from the photosensitive layer 20. In the exposure step, development may then be performed by removing the unexposed sections (non-photocured sections) of the photosensitive layer 20 by wet development using a developing solution such as an aqueous alkali solution, aqueous developing solution or organic solvent, or dry development, to produce a resist pattern.

As examples of aqueous alkali solutions there may be mentioned a 0.1-5 wt% sodium carbonate dilute solution, a 0.1-5 wt% potassium carbonate dilute solution or a 0.1-5 wt% sodium hydroxide dilute solution. The pH of the aqueous alkali solution is preferably in the range of 9-11, and the temperature is adjusted as appropriate for the developing property of the photosensitive layer 20. The aqueous alkali solution may also contain added surfactants, antifoaming agents, organic solvents and the like. The developing system may be, for example, a dip system, a spray system, brushing or slapping.

Treatment following the developing step may consist of heating at about 60-250°C or exposure at about 0.2-10 J/cm² if necessary for further curing of the resist pattern.

### (Printed wiring board production process).

The process for production of a printed wiring board according to this embodiment may be carried out by etching or plating the circuit-forming board having the resist pattern formed by the resist pattern forming method described above. The etching or plating of the circuit-forming board is accomplished by etching or plating the surface of the circuit-forming board by a known process using the developed resist pattern as a mask.

The etching solution used for etching may be, for example, a cupric chloride solution, ferric chloride solution, alkali etching or solution.

As examples of methods for plating there may be mentioned copper plating, solder plating, nickel plating and gold plating.

After the etching or plating, the resist pattern may be released, for example, with an aqueous solution of stronger alkalinity than the aqueous alkali solution used for development. The strongly alkaline aqueous solution used here may be, for example, a sodium hydroxide aqueous solution at 1-10 parts by weight or a potassium hydroxide aqueous solution at 1-10 parts by weight. The releasing system may be, for example, a dipping system and spray system. The printed wiring board on which the resist pattern has been formed may be a multilayer printed wiring board, and it may also have small through-holes.

When the plating is carried out for a circuit-forming board provided with an insulating layer and a conductive layer formed on the insulating layer, the sections of the conductive layer other than the pattern must be removed. As examples of removal methods there may be mentioned a method of releasing the resist pattern and then lightly etching, and a method of performing solder plating or the like after plating and then removing the resist pattern to leave a solder mask on the wiring sections, and finally carrying out treatment using an etching solution capable of etching only the conductive layer.

According to the photosensitive element, resist pattern forming method and printed wiring board production process of the embodiment described above, the photosensitive element 1 comprises a support film 10 with a haze of no greater than 1.0%. This will allow formation of photocured sections on the photosensitive layer 20 with sufficiently high resolution and photosensitivity when the photosensitive layer 20 is irradiated with active light rays through the support film 10. The obtained resist pattern and the circuit pattern on the printed wiring board will therefore also have sufficiently high resolution, thus permitting an even higher density circuit to be obtained.

The support film 10 of the photosensitive element 1 also has a surface resistivity of no greater than 10¹³ Ω. This will help prevent sticking between the support film 10 and the photosensitive layer 20 or protective film in the photosensitive element 1 that has been wound into a roll. It will also adequately inhibit adhesion of contaminants such as dust and dirt onto the second main side 14 of the support film 10. It will thus be possible to adequately prevent inhibition of bonding due to contaminants when the photomask is bonded to the second main side 14 of the support film 10. In addition, patterning problems caused by irradiation of active light rays through adhering contaminants will also be satisfactorily prevented. It will also be possible to sufficiently inhibit strong adhesion of the photomask onto the support film 10. This will facilitate positioning of the photomask and release and removal of the photomask from the support film 10, thus improving workability. As a result, production efficiency for printed wiring boards can be improved and an increased yield can be obtained.

A photosensitive element provided with a layer comprising a photosensitive resin composition that contains a photopolymerizing agent, a photopolymerizing compound and a binder polymer which includes (meth)acrylic acid and an alkyl (meth)acrylate wherein the alkyl group of the ester portion has 3-7 carbon atoms, as a compound represented by general formula (I) above, exhibits excellent adhesiveness, resolution, post-development resist form, flexibility and post-plating release property, and thus can contribute to obtaining higher-density printed wiring boards.

The invention was explained above in detail based on embodiments thereof. However, the invention is not limited to the embodiments described above, and it may also be applied in a variety of modifications so long as the gist thereof is maintained.

### Examples

Preferred examples of the invention will now be explained in greater detail, with the understanding that these examples are in no way limitative on the invention.

### [Synthesis of binder polymers]

Binder polymers (I)-(IV) containing the compounds listed in Table 1 as monomer units were synthesized by radical polymerization, to obtain a 60 wt% toluene/methylcellosolve (weight ratio: 4/6) solution.

**[Table 1]**

| Binder polymer | I | II | III | IV |
|---|---|---|---|---|
| Methacrylic acid (wt%) | 30 | 30 | 30 | 30 |
| Methyl methacrylate (wt%) | 35 | 30 | 35 | 40 |
| Butyl methacrylate (wt%) | 35 | 30 | - | - |
| Decyl methacrylate (wt%) | - | - | 35 | - |
| Styrene (wt%) | - | 10 | - | 30 |
| Weight-average molecular weight | 40000 | 40000 | 40000 | 40000 |

### [Preparation of photosensitive resin composition]

The synthesized binder polymers (I)-(IV) were each used to prepare photosensitive resin compositions by combining 2,2-bis(4-(methacryloxypentadecaethoxy)phenyl)propane and EO-modified nonylphenyl acrylate as photopolymerizing compounds, N,N'-tetraethyl-4,4'-diaminobenzophenone and 2-(o-chiorophenyl)-4,5-diphenylirnidazole dimer as photopolymerization initiators, the photochromic agent Leuco crystal violet, the dye Malachite green and the plasticizer p-Toluenesulfonic acid amide as additional components, and acetone, toluene, methanol and N,N-dimethylformamide as solvents, in the mixing ratios listed in Table 2.

**[Table 2]**

| Component | Compound | |
|---|---|---|
| Binder polymer | Binder polymer (I), (II), (III) or (IV) | 150 (60 g solid weight) |
| Photopolymerizing compound | 2,2-Bis(4-(methacryloxypentadecaethoxy) phenyl)propane | 30.0 |
| | EO-modified nonylphenyl acrylate (ethylene glycol chain repeating units: 8) | 10.0 |
| Photopolymerization initiator | N,N'-Tetraethyl-4,4'-diaminabezophenone | 0.15 |
| | 2-(o-Chlorophenyl)-4,5-diphenylimidazole dimer | 3.0 |
| Other components | Leuco crystal violet | 0.5 |
| | Malachite green | 0.05 |
| | p-Toluenesulfonic acid amide | 4.0 |
| Solvent | Acetone | 10.0 |
| | Toluene | 10.0 |
| | Methanol | 3.0 |
| | N,N-Dimethylformamide | 3.0 |

### [Measurement of surface resistivity of support film]

The surface resistivity of the support film was measured according to JIS C 2151, under the following conditions.
Measuring device: Model 4329A High Resistance Meter by
Hewlett-Packard
Measuring temperature: 26°C.
Measuring voltage: DC 250 V
Measuring time: 1 minute
Measuring electrode: Main electrode inner diameter = ϕ50 mm, counter electrode inner diameter = ϕ70 mm, no guard electrode

### [Fabrication of photosensitive elements]

### (Example 1)

A polyethylene terephthalate (hereinafter, "PET") film (trade name: "A-1517" by Toyobo, Ltd., thickness: 16 µm) was prepared as a support film. The PET film was coated with the prepared photosensitive resin composition containing the binder polymer (I) to a uniform thickness and dried for 2 minutes with a hot air convection current drier at 100ºC to remove the solvent and form a photosensitive layer. After drying, the photosensitive layer was covered with a polyethylene film (trade name: "NF-15" by Tamapoly Co., Ltd., thickness: 20 µm) as a protective film to obtain a photosensitive element. The post-drying thickness of the photosensitive layer was 25 µm.

### (Example 2)

A photosensitive element was obtained in the same manner as Example 1, except that a photosensitive resin composition containing binder polymer (II) was used instead of binder polymer (I). The post-drying thickness of the photosensitive layer was 25 µm.

### (Comparative Example 1)

A photosensitive element was obtained in the same manner as Example 1, except that a photosensitive resin composition containing binder polymer (III) was used instead of binder polymer (I). The post-drying thickness of the photosensitive layer was 25 µm.

### (Comparative Example 2)

A photosensitive element was obtained in the same manner as Example 1, except that a photosensitive resin composition containing binder polymer (IV) was used instead of binder polymer (I). The post-drying thickness of the photosensitive layer was 25 µm.

### (Comparative Example 3)

A photosensitive element was obtained in the same manner as Example 1, except that a PET film (trade name: "HTF-01" by Teijin-DuPont Films, thickness: 16 µm) was used instead of the PET film "A-1517". The post-drying thickness of the photosensitive layer was 25 µm.

### (Comparative Example 4)

A photosensitive element was obtained in the same manner as Example 1, except that a PET film (trade name: "G2-16" by Teijin-DuPont Films, thickness: 16 µm) was used instead of the PET film "A-1517". The post-drying thickness of the photosensitive layer was 25 µm.

### [Fabrication of laminated bodies]

The copper surface of a copper clad laminate ("MLC-E-679", trade name of Hitachi Chemical Co., Ltd.) comprising a glass epoxy material laminated on both sides of a copper foil (thickness: 35 µm) was polished using a polishing machine with a #600-equivalent brush (Sankei Co., Ltd.), and after cleaning with water, it was dried with an air stream. The copper clad laminate was heated to 80°C, and the photosensitive elements of each of Examples 1 and 2 and Comparative Examples 1-4 were laminated thereon while releasing the protective film from the photosensitive element, in such a manner that the photosensitive layer contacted the copper surface. Laminated bodies were thus obtained each comprising a copper clad laminate, photosensitive layer and support film laminated in that order. The lamination was carried out using a heat roll at 120°C, with a contact bonding pressure of 0.4 MPa and a roll speed of 1.5 m/min. The laminated bodies were used as test specimens for the following tests.

### <Evaluation of minimum developing time>

The PET film was released from the test specimen, and 1 wt% aqueous sodium carbonate at 30°C was used to evaluate the minimum time allowing complete removal of the photosensitive layer at the unexposed sections (minimum developing time, in seconds). The results are shown in Table 3.

### <Evaluation of photosensitivity>

A Stouffer 21-step tablet was placed on the support film of the test specimen, and an exposure apparatus with a high-pressure mercury lamp (trade name: "EXM-1201" by Orc Manufacturing Co., Ltd.) was used for exposure of the photosensitive layer at an energy dose of 60 mJ/cm². The PET film serving as the support film was released, and 1 wt% aqueous sodium carbonate at 30°C was sprayed for twice the minimum developing time to remove the unexposed sections. The number of steps of the step tablet of the photocured film formed on the copper clad laminate was then measured to evaluate the photosensitivity of the photosensitive resin composition. The results are shown in Table 3. The photosensitivity is indicated by the number of steps of the step tablet, with a higher step tablet step number representing higher photosensitivity.

### <Evaluation of resolution>

In order to investigate the resolution, a phototool with a Stouffer 21-step tablet and a glass chromium-type phototool having a wiring pattern with a line width/space width of 2/2-30/30 (units: µm) as a negative for evaluation of resolution were adhered to the support film of the test specimen, and an exposure apparatus equipped with a high-pressure mercury lamp was used to provide an irradiated energy dose for a residual step number of 8.0 after development of the Stouffer 21-step tablet. The support film was released, and 1 wt% aqueous sodium carbonate at 30°C was sprayed for twice the minimum developing time to remove the unexposed sections, for development. The resolution was evaluated based on the smallest value for the space width between line widths that allowed clean removal of the unexposed sections by developing treatment (units: µm). The results are shown in Table 3. Small values are desirable for the resolution evaluation.

### <Evaluation of adhesiveness>

In order to investigate the adhesiveness, a phototool with a Stouffer 21-step tablet and a glass chromium-type phototool having a wiring pattern with a line width/space width of 2/1000-30/1000 (units: µm) as a negative for evaluation of adhesiveness were adhered to the support film of the test specimen, and an exposure apparatus equipped with a high-pressure mercury lamp was used to provide an irradiated energy dose for a residual step number of 8.0 after development of the Stouffer 21-step tablet. The support film was released, and 1 wt% aqueous sodium carbonate at 30°C was sprayed for twice the minimum developing time to remove the unexposed sections, for development. The resolution was evaluated based on the smallest value for the line width that allowed clean removal of the unexposed sections by developing treatment (units: µm). The results are shown in Table 3. Small values are desirable for the adhesiveness evaluation.

### <Evaluation of post-plating release property>

In order to examine the post-plating release property, the same procedure was carried out as in the resolution measurement test, up to development. The developed test specimen was then treated by dipping in an aqueous solution containing a mixture of CupraPro S2 (product of Atotech Japan) and 6 vol% sulfuric acid at a temperature of 40°C for 6 minutes, and after washing for 3 minutes with running water, it was dipped in 10 vol% aqueous sulfuric acid for 30 seconds. The copper sulfate plating solution described below was then used for plating with a current density of 1.2 A/dm² to a thickness of 0.8 times the resist film thickness. The composition of the copper sulfate plating solution was 60 g/L of copper sulfate pentahydrate, 98 mL/L of 98% sulfuric acid, 100 mg/L of sodium chloride, and 3 mL/L of the basic leveler Kapalacid HL (product of Atotech Japan) and the brightening agent Kapalacid Universal (product of Atotech Japan). Next, the plated test specimen was washed for 1 minute with running water and sprayed for 3 minutes with 3 wt% aqueous sodium hydroxide at 50°C, and the resist was released. The release residue after plating was evaluated based on the smallest value (units: µm) of the line width which allowed the resist to be released without problems. The results are shown in Table 2. Smaller values are desirable for the post-plating release property.

### <Evaluation of resist pattern edge form>

The edge form (resist edge form) of the copper plating line in the post-plating release property test was observed with a scanning electron microscope (SEM) and evaluated on a 3-level scale of A, B, C according to the following criteria. The results are shown in Table 3. A satisfactory edge form of the copper plating lines corresponds to a satisfactory resist pattern edge form.
A: Smooth edge form.
B: Edge form smoothness intermediate between A and C.
C: Rough edge form.

### <Evaluation of resist skirt trailing>

Laminated bodies were obtained comprising the photosensitive elements obtained in Examples 1 and 2 and Comparative Examples 1-4 laminated on polyimide bases, by the same procedure as for the laminated body fabrication described above, except that instead of the copper-clad laminate comprising a glass epoxy material laminated with copper foil on both sides for fabrication of the laminated bodies there was used a polyimide base obtained by acid washing a copper-vapor deposited polyimide base with 1 vol% aqueous hydrochloric acid, rinsing it and then drying it with an air stream. Each laminated body was used to form a resist pattern by exposure and development following the same procedure as in the previously conducted resolution test. The cross-sectional form of the formed resist pattern was observed with a focused ion beam (FIB) apparatus and a scanning electron microscope (SEM), and the extent of skirt trailing (units: µm) of the resist pattern was determined. The results are shown in Table 3. Small values are desirable for skirt trailing.

### <Evaluation of resist flexibility>

The resist flexibility was evaluated using a test specimen having a resist pattern formed by the same procedure as described above using a laminated body similar to that used for evaluation of the resist skirt trailing. The test specimen was cut to a width of 2 cm and then mounted on a mandrel folded approximately 180 degrees and subjected to 5 strokes on a board, and the minimum mandrel diameter with which no resist peeling occurred was determined (units: mm). The results are shown in Table 3. A smaller value for the mandrel diameter corresponds to more excellent resist flexibility.

### <Static electricity generation measurement test>

First, the laminated body was wound onto a roll with the support film facing outward. The laminated body wound as a roll was then reeled out from the edge. The static electricity generation of the support film immediately after reeling out was measured using an electrostatic field meter (trade name: "FMX-002" by Simco, Japan). The static electricity generation by the support film was measured on the main side that was in contact with the protective film in the wound state. The static electricity generation was measured as the electrostatic potential (units: kV). The results are shown in Table 3.

**[Table 3]**

| | | Example 1 | Example 2 | Comp. Ex. 1 | Comp. Ex. 2 | Comp. Ex. 3 | Comp. Ex. 4 |
|---|---|---|---|---|---|---|---|
| Support film | Trade name | A-1517 | A-1517 | A-1517 | A-1517 | HTF-01 | G2-16 |
| | Haze | 0.2 | 0.2 | 0.2 | 0.2 | 0.2 | 3.5 |
| | Surface resistivity (Ω) | 1.1 × 10¹² | 1.1 × 10¹² | 1.1 ×10¹² | 1.1 × 10¹² | 1.7 × 10¹⁴ | 3.8 ×10¹¹ |
| Binder polymer | | I | II | III | IV | I | I |
| Minimum developing time (sec) | | 15 | 18 | 17 | 23 | 15 | 15 |
| Photosensitivity | | 8 | 8 | 8 | 8 | 8 | 8 |
| Adhesiveness (µm) | | 14 | 13 | 25 | 13 | 14 | 12 |
| Resolution (µm) | | 12 | 13 | 20 | 14 | 12 | 20 |
| Post-plating release property (µm) | | 12 | 13 | 30 | 20 | 12 | 20 |
| Copper plating line edge form (resist edge form) | | A | A | A | A | A | C |
| Resist skit trailing (µm) | | 0.4 | 0.4 | 0.3 | 0.3 | 0.4 | 0.8 |
| Flexibility (mm) | | 4 | 4 | 3 | 10 | 4 | 4 |
| Electrostatic generation (kV) | | 0.1 | 0.1 | 0.1 | 0.1 | 5.8 | 0 |

As clearly seen in Table 3, the photosensitive elements obtained for the examples exhibited excellent adhesiveness, resolution, post-plating release property, copper plating line edge form (resist edge form) and flexibility, while also generating low static electricity.

### Industrial Applicability

According to the invention it is possible to provide a photosensitive element that has sufficiently reduced adhesion of contaminants and attachment of photomasks onto support films, that allows formation of resist patterns with adequately high resolution and high sensitivity, and that exhibits satisfactorily excellent adhesiveness, post-development resist form, flexibility and post-plating release properties.

## Claims

1. A photosensitive element comprising a support film, and a layer composed of a photosensitive resin composition and formed on the first main side of the support film,
wherein the haze of the support film is no greater than 1.0%, the surface resistivity of the second main side opposite the first main side of the support film is no greater than 10¹³ Ω, and
the layer composed of the photosensitive resin composition contains a photopolymerizing compound, a photopolymerization initiator and a binder polymer comprising a compound represented by the following general formula (I) and (meth)acrylic acid as monomer units.
[Chemical Formula 1] H₂C=CR¹-COOR² (I)
[In formula (I), R¹ represents hydrogen or a methyl group, and R² represents a C3-7 alkyl group.]

2. A photosensitive element according to claim 1, wherein the binder polymer contains as monomer units, 5-45 wt% of a compound represented by the general formula (I) and 20-40 wt% of (meth)acrylic acid.

3. A photosensitive element according to claim 1, wherein the binder polymer further contains styrene and/or a styrene derivative as monomer units.

4. A photosensitive element according to any one of claims 1 to 3, wherein the support film is a film comprising as the major component one or more polymers selected from the group consisting of polyethylene terephthalate, polypropylene, polyethylene and polyesters.
